# EUROPÄISCHE PATENTSCHRIFT

(11) **EP 0 920 130 B1**
(45) Veröffentlichungstag und Bekanntmachung des Hinweises auf die Patenterteilung: **24.03.2004**
(21) Anmeldenummer: 98203911.7
(22) Anmeldetag: 18.11.1998
(51) Int. Cl.: H03H 11/04, H03D 7/14

(54) **Integrator-Filterschaltung**
Integrator-filter circuit
Circuit filtre-intégrateur

(30) Priorität: 29.11.1997 DE 19753095
(43) Veröffentlichungstag der Anmeldung: 02.06.1999
(73) Patentinhaber: Philips Intellectual Property & Standards GmbH, 20099 Hamburg (DE); Koninklijke Philips Electronics N.V., 5621 BA Eindhoven (NL)
(72) Erfinder: Kattner, Axel, 22335 Hamburg (DE); Gehrt, Holger, 22335 Hamburg (DE)
(74) Vertreter: von Laue, Hanns-Ulrich, Dipl.-Ing.

(56) Entgegenhaltungen:
- GB-A- 2 064 253
- FICHTEL J ET AL: "DESIGN AND APPLICATIONS OF TUNABLE ANALOG BICMOS CIRCUITS" IEEE JOURNAL OF SOLID-STATE CIRCUITS,US,IEEE INC. NEW YORK, Bd. 27, Nr. 7, 1. Juli 1992 (1992-07-01), Seiten 1101-1104, XP000304449 ISSN: 0018-9200
- PATENT ABSTRACTS OF JAPAN vol. 018, no. 560 (E-1621), 26. Oktober 1994 (1994-10-26) & JP 06 204787 A (MITSUBISHI ELECTRIC CORP), 22. Juli 1994 (1994-07-22)

## Beschreibung

Die Erfindung betrifft eine Integrator-Filterschaltung zur Filterung eines Gegentaktsignals mit wenigstens zwei Integrator-Elementen, welche jeweils eingangsseitig angeordnete Widerstände, einen diesen nachgeschalteten Strom-Multiplizierer mit zwei Signaleingängen und einen diesem nachgeschalteten Gegentaktverstärker mit einem invertierenden und einem nichtinvertierenden Eingang aufweisen, dessen invertierender Ausgang auf den nichtinvertierenden Eingang und dessen nichtinvertierender Ausgang auf dessen invertierenden Eingang über Kapazitäten rückgekoppelt ist, wobei dem Strom-Multiplizierer an zwei Steuereingängen ein erster und ein zweiter Steuerstrom zugeführt werden, mittels derer die Integrations-Zeitkonstante der Integrator-Elemente einstellbar ist und von denen der zweite Steuerstrom etwa je hälftig durch die Signaleingänge des Strom-Multiplizierers fließt.

Derartige Integrator-Filterschaltungen sind beispielsweise aus dem Philips-IC TDA 9715 bekannt; dort werden sie beispielsweise zur Farbträgerfilterung in einem Videosignal eingesetzt. Ebenfalls bekannt sind derartige Filter aus: "Integrated Continous-Time Filter", Y. P. Tsinidis, J. O. Voorman, IEEE Press, 1992/93.

Derartige Integrator-Filterschaltungen zeichnen sich vor allem dadurch aus, daß sie mittels des ersten und des zweiten Steuerstroms bezüglich ihrer Filterfrequenz einstellbar sind. Dazu sind innerhalb der Integrator-Filterschaltung mehrere Integratorelemente in geeigneter Weise verschaltet. Innerhalb jedes Integratorelementes ist ein Gegentaktverstärker vorgesehen, dem ein Strom-Multiplizierer vorgeschaltet ist, der auch als Gilbert-Multiplizierer bezeichnet wird. Die Ausgänge des Gegentaktverstärkers sind über Kapazitäten auf dessen Eingänge rückgekoppelt. Dem Strom-Multiplizierer sind Widerstände vorgeschaltet. Die Steuerströme werden dem Strom-Multiplizierer an Steuereingängen zugeführt. Durch Variation der Steuerströme kann die Impedanz am Eingang des Gegentaktverstärkers variiert werden. Hierdurch wird die Zeitkonstante bzw. Integrationszeitkonstante variiert.

Der Nachteil derartiger Integrator-Filterschaltungen bzw. der in ihnen vorgesehenen Integrator-Elemente besteht vor allem darin, daß der zweite Steuerstrom auch in den Eingängen des Strom-Multiplizierers fließt. Der Steuerstrom tritt dabei etwa je hälftig an den beiden Eingängen auf. Da somit dieser Steuerstrom auch durch die dem Strom-Multiplizierer vorgeschalteten Widerstände fließt, wird der Aussteuerbereich, den das zu filternde Signal aufweisen darf, durch die Größe der Steuerströme beeinflußt. Dementsprechend ist der Aussteuerbereich bei kleinem Steuerstrom reduziert.

Es ist Aufgabe der Erfindung, eine derartige Integrator-Filterschaltung dahingehend weiterzuenwickeln, daß ihr Aussteuerbereich unabhängig von der Größe der Steuerströme weitgehend konstant bleibt.

Diese Aufgabe wird erfindungsgemäß dadurch gelöst, daß ein zugeordneter dritter Steuerstrom erzeugt wird, welcher in Abhängigkeit einer zweiten Steuerspannung generiert wird, bei deren Variation der dritte Steuerstrom sich proportional zu dem zweiten Steuerstrom ändert, daß für jedes Integrator-Element eine zugeordnete Kompensationsschaltung vorgesehen ist, die eine erste Stromspiegelschaltung, welche in Abhängigkeit des dritten Steuerstromes zwei etwa gleich große Ausgleichsströme erzeugt, und eine zweite Stromspiegelschaltung aufweist, welche in Abhängigkeit eines Referenzstromes zwei gleich große Referenzsteuerströme erzeugt, welche zur Erzeugung zweier Kompensationsströme mit den Ausgleichsströmen überlagert werden, und daß der dritte Steuerstrom und die zugeordneten Kompensationsschaltungen so dimensioniert sind, daß in Folge der Einspeisung der Kompensationsströme an den Signaleingängen der Multiplizierer der Integrator-Elemente bei einer Veränderung der Größe des zweiten Steuerstromes die durch die Widerstände fließenden Summenströme aus jeweils halbem zweitem Steuerstrom und Kompensationsstrom etwa konstant bleiben.

Erfindungsgemäß wird zusätzlich zu den beiden dem Strom-Multiplizierer zugeführten Steuerströmen, also dem ersten und zweiten Steuerstrom, ein dritter Steuerstrom erzeugt. Die Größe des dritten Steuerstromes ist proportional zum zweiten Steuerstrom, d.h. also bei einer Variation des zweiten Steuerstromes ändert sich der dritte Steuerstrom in proportionaler Weise.

Der dritte Steuerstrom wird einer Kompensationsschaltung zugeführt, welche eine erste Stromspiegelschaltung aufweist, welche in Abhängigkeit des dritten Steuerstromes zwei etwa gleich große Ausgleichsströme erzeugt. Eine innerhalb der Kompensationsschaltung vorgesehene zweite Stromspiegelschaltung erzeugt in Abhängigkeit eines Referenzstromes zwei ebenfalls etwa gleich große Referenzsteuerströme. Die Referenzsteuerströme der zweiten Stromspiegelschaltung und die Ausgleichsströme der ersten Stromspiegelschaltung werden überlagert. Dabei entstehen Kompensationsströme, die ebenfalls etwa gleich groß sind und von denen jeweils einer jeweils einem Signaleingang des Strom-Multiplizierers zugeführt wird. Dort überlagern sich diese Kompensationsströme mit den Anteilen des zweiten Steuerstromes, die an den Eingängen des Strom-Multiplizierers auftreten.

Die Größe des dritten Steuerstromes und die Kompensationsschaltung sind so dimensioniert, daß die Überlagerung der Kompensationsströme mit den an den Eingängen des Multiplizierers auftretenden Anteilen des zweiten Steuerstromes insgesamt einen konstanten Stromfluß durch die Widerstände und damit einen konstanten Aussteuerbereich des Integrator-Elementes bewirkt. Mit anderen Worten kann man sagen, daß die Kompensationsströme so ausgelegt sind, daß sie jede Veränderung der Anteile des zweiten Steuerstromes an den Eingängen des Strom-Multiplizierers kompensieren; die Kompensationsströme haben also etwa gleiche Größe und umgekehrtes Vorzeichen wie die Veränderungen der Anteile des zweiten Steuerstromes am Strom-Multiplizierer bei einer Veränderung der zweiten Steuerspannung. Infolgedessen bleiben auch bei einer Veränderung des zweiten Steuerstromes die in den Widerständen fließenden Ströme konstant, da der veränderte Anteil des zweiten Steuerstromes in den Eingängen des Strom-Multiplizierers durch die Kompensationsströme kompensiert wird. Da somit durch die Widerstände unabhängig von der Größe des zweiten Steuerstromes immer Ströme etwa konstanter Größe fließen, bleibt auch der Aussteuerungsbereich des Integrator-Elementes in diesem Bereich konstant.

Der dritte Steuerstrom und der Referenzstrom können individuell für jedes Integrator-Element oder für jede Integrator-Filterschaltung erzeugt werden, sie können vorteilhaft jedoch auch gemeinsam für mehrere Filterschaltungen erzeugt werden. In Abhängigkeit des gegebenenfalls gemeinsam erzeugten dritten Steuerstroms werden jedoch für jedes Integrator-Element erste und zweite Steuerströme individuell generiert.

Eine Ausgestaltung der Erfindung ergibt sich aus Anspruch 2. Dabei ist die Kompensationsschaltung so ausgelegt, daß die Kompensationsströme bei einer Referenz-Integrations-Zeitkonstante des Integrations-Elementes Null betragen. Diese Referenz-Integrations-Zeitkonstante ist vorzugsweise so gewählt, daß sie in einem mittleren Bereich des möglichen Einstellbereichs der Integrations-Zeitkonstante liegt. Bei dieser Referenz-Integrations-Zeitkonstante fließen keine Kompensationsströme. Wird die Integrations-Zeitkonstante verändert, weicht sie also von der Referenz-Integrations-Zeitkonstante ab, so nehmen die Kompensationsströme mit zunehmender Abweichung ebenfalls zu. Sie sind bezüglich Betrag und Vorzeichen so ausgelegt, daß wiederum eine Kompensation derjenigen Anteile des zweiten Steuerstromes am Eingang des Multiplizierers auftritt, die dort in Abweichung derjenigen Ströme auftreten, die bei Abstimmung auf die Referenz-Integrations-Zeitkonstante auftreten.

Diese Auslegung hat den Vorteil, daß die Kompensationsströme relativ klein gehalten werden können, da sie im Bereich der Referenz-Integrations-Zeitkonstante Null betragen und gegenüber dieser Zeitkonstante zu beiden Seiten relativ kleine Variationen der Anteile des zweiten Steuerstromes an den Signaleingängen des Multiplizierers auftreten, die durch relativ kleine Kompensationsströme kompensiert werden können.

In Anspruch 3 ist eine vorteilhafte Art der Erzeugung des ersten und des zweiten Steuerstromes angegeben.

Wie gemäß einer weiteren Ausgestaltung nach Anspruch 4 vorgesehen ist, können die ersten und zweiten Steuerströme der Integrator-Elemente sowohl für die Feinabstimmung der Integrator-Zeitkonstanten wie auch für eine gröbere Verstimmung der Integrator-Zeitkonstanten eingesetzt werden. Insbesondere die Wahl relativ weit auseinanderliegender Integrator-Zeitkonstanten durch die Erfindung ist problemlos möglich, da auch bei relativ starker Veränderung der Integrator-Zeitkonstanten der Aussteuerbereich des Integrator-Elementes konstant bleibt.

Eine Integrator-Filterschaltung der erfindungsgemäßen Art ist für vielfältige Einsatzzwecke auslegbar, da insbesondere die Wahl der Integrator-Zeitkonstanten und damit der Filterfrequenzen der gesamten Filteranordnung frei ist bzw. diese Frequenzen gewünschten Filterfrequenzen ohne Nachteile bezüglich der Aussteuerbarkeit leicht anpaßbar sind. So kann die erfindungsgemäße Integrator-Filterschaltung beispielsweise für die Einsatzzwecke gemäß den Ansprüchen 6 oder 7 ausgelegt sein.

Beispielsweise für die Ausfilterung eines oder mehrerer Tonträger, die in einem Video-Signal enthalten sind, können vorteilhaft Filteranordnungen nach den Ansprüchen 10 oder 11 eingesetzt werden, bei denen mehrere Integrator-Filterschaltungen hintereinandergeschaltet sind und jeweils auf verschiedene Frequenzen abgestimmt sind. Damit kann einerseits erreicht werden, daß mehrere Trägerfrequenzen ausgefiltert werden. Andererseits können Träger mit relativ großer Amplitude mittels beispielsweise zweier Integrator-Filterschaltungen stärker gedämpft werden als andere Träger, die eine kleinere Amplitude aufweisen und die beispielsweise mittels einer Integrator-Filterschaltung gedämpft werden. Damit kann im Ergebnis erreicht werden, daß nach der Filterung die Träger, die ursprünglich verschieden große Amplituden aufweisen, etwa auf einen gleichen Wert gedämpft werden.

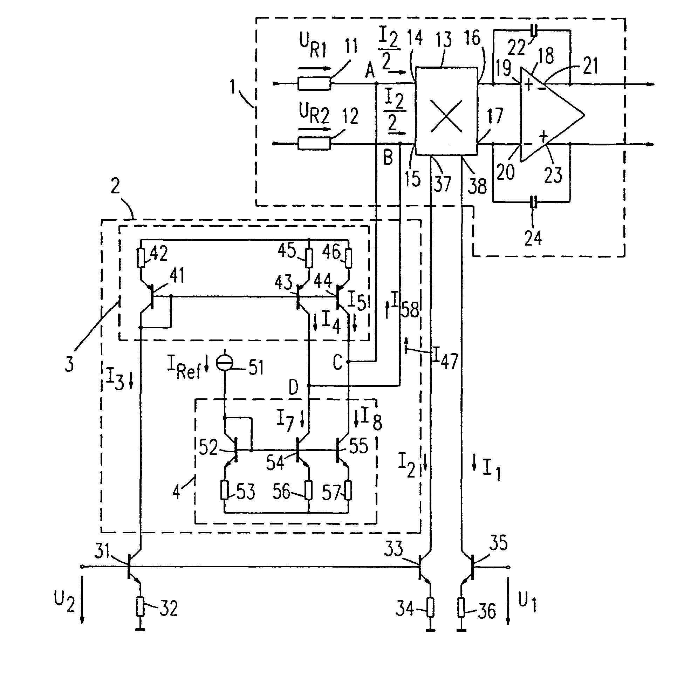

Die einzige Figur der Zeichnung zeigt in Form eines Blockschaltbildes ein Integrator-Element 1 und zugeordnete Schaltungen zur Erzeugung von Steuerströmen sowie eine zugeordnete Kompensationsschaltung. Innerhalb einer Filteranordnung sind mehrere derartige Integrator-Elemente mit den zugeordneten Elementen, insbesondere jeweils einer zugeordneten Kompensationsschaltung, vorgesehen. Die Zahl der verwendeten Integrator-Elemente bestimmt die Ordnung der Filterschaltung.

Eine solche Integrator-Filterschaltung kann beispielsweise zur Ausfilterung eines Tonträgers in einem Video-Signal dienen. Zur Ausfilterung mehrerer Tonträger verschiedener Frequenzen können mehrere Integrator-Filterschaltungen hintereinandergeschaltet werden.

Dem in der Figur dargestellten Integrator-Element 1 wird ein Gegentaktsignal zugeführt, das beispielsweise ein balanciertes Video-Signal mit darin enthaltenen Tonträgern sein kann.

Das balancierte bzw. Gegentaktsignal wird innerhalb des Integrator-Elementes 1 Widerständen 11 und 12 zugeführt. Den Widerständen 11 bzw. 12 sind Signal-Eingänge 14 bzw. 15 eines Strom-Multiplizierers 13 nachgeschaltet, der auch als Gilbert-Multiplizierer bezeichnet wird. An Ausgängen 16 bzw. 17 des Strom-Multiplizierers 13 liegt wiederum ein Gegentaktsignal vor, das einem nichtinvertierenden Eingang 19 bzw. einem invertierenden Eingang 20 eines Gegentaktverstärkers 18 zugeführt wird.

An einem invertierenden Ausgang 21 des Gegentaktverstärkers 18 tritt das verstärkte Signal des Eingangs 19 auf. Dieses Signal ist einerseits eine Signalkomponente des Gegentaktsignals am Ausgang des Integrator-Elementes 1 und wird andererseits über eine Kapazität 22 auf den nichtinvertierenden Eingang 19 rückgekoppelt.

In entsprechender Weise liefert ein nichtinvertierender Ausgang 23 das verstärkte Eingangssignal des invertierenden Eingangs 20, das ebenfalls eine Komponente des Ausgangs-Gegentakt-Signals des Integrator-Elementes 1 darstellt und das über eine Kapazität 24 auf den invertierenden Eingang 20 rückgekoppelt ist.

Die Steuerung der Integrations-Zeitkonstanten des Integrator-Elementes 1 ist mittels eines ersten Steuerstromes I₁ und eines zweiten Steuerstromes I₂ einstellbar. Dabei gilt für die Integrations-Zeitkonstante die Beziehung t=R•C•I₂/I₁. In dieser Gleichung repräsentiert R die Widerstände 11 und 12 und C die Kapazitäten 22 bzw. 24. Es ist also ohne Veränderung der Widerstände bzw. der Kapazitäten eine Abstimmung der Integrations-Zeitkonstante des Integrations-Elementes 1 möglich.

Die Relation der beiden Steuerströme I₁, und I₂ kann zur Einstellung dieser Zeitkonstanten eingesetzt werden.

Es tritt hierbei jedoch der Nachteil auf, daß der Steuerstrom I₂ etwa in jeweils halber Größe ebenfalls an den Eingängen 14 und 15 des Strom-Multiplizierers 13 fließt. Er fließt damit über Anordnungen nach dem Stande der Technik in unveränderter Größe auch in den Widerständen 11 und 12. Wird nun der Steuerstrom I₂ bezüglich seiner Größe zur Einstellung der Integrations-Frequenz variiert, insbesondere verkleinert, tritt ein entsprechend verkleinerter halbierter Steuerstrom auch in den Widerständen 11 und 12 auf. Dies hat zur Folge, daß sich der mögliche Aussteuerbereich des Integrations-Elementes 1 entsprechend verkleinert. Der Aussteuerbereich des Integrations-Elementes 1 ist also abhängig von dem zweiten Steuerstrom und damit abhängig von der eingestellten Integrations-Zeitkonstante. Dieser Effekt ist unerwünscht und soll durch die erfindungsgemäße Integrator-Filterschaltung beseitigt werden. Dies geschieht durch geeignete Erzeugung zweier Kompensations-Ströme I₄₇ und I₅₈, die den Verbindungspunkten zwischen den Widerständen 11 und 12 und den Eingängen 14 und 15 des Strom-Multiplizierers 13 zugeführt werden und die Veränderungen der an den Eingängen 14 bzw. 15 des Strom-Multiplizierers 13 auftretenden Anteile des zweiten Steuerstromes kompensieren.

Hierzu wird ein dritter Steuerstrom I₃ generiert, der bei Variation des zweiten Steuerstromes I₂ sich proportional zu diesem verändert.

In dem Ausführungsbeispiel gemäß der Figur wird dies dadurch erreicht, daß sowohl der zweite Steuerstrom I₂ wie auch der dritte Steuerstrom I₃ in Abhängigkeit einer zweiten Steuerspannung U₂ generiert werden. Die zweite Steuerspannung U₂ wird Basisanschlüssen zweier Transistoren 31 und 33 zugeführt, deren Emitter jeweils über Widerstände 32 bzw. 34 auf ein Bezugspotential geführt sind. Es fließt dann in Abhängigkeit der zweiten Steuerspannung U₂ durch den Kollektor des Transistors 31 der dritte Steuerstrom I₃ und durch den Kollektor des Transistors 33 der zweite Steuerstrom I₂. Infolge der gemeinsamen Abhängigkeit von der zweiten Steuerspannung U₂ verhalten sich die beiden Steuerströme I₂ und I₃ proportional zueinander.

In entsprechender Weise kann vorteilhaft auch der erste Steuerstrom I₁ mittels eines in gleicher Weise verschalteten Transistors 35 und eines Widerstandes 36 in Abhängigkeit einer ersten Steuerspannung U₁ erzeugt werden.

Die erfindungsgemäße Integrator-Filterschaltung weist eine KompensationsSchaltung 2 auf, der der dritte Steuerstrom zugeführt wird und die ihrerseits eine erste Stromspiegel-Schaltung 3 und eine zweite Stromspiegel-Schaltung 4 aufweist.

Der ersten Stromspiegel-Schaltung 3 wird an ihrem Eingang der Steuerstrom I₃ zugeführt, der zu zwei etwa gleich großen Ausgleichsströmen I₄ und I₅ gespiegelt wird. Dies geschieht in an sich bekannter Weise mittels einer Stromspiegel-Schaltung, welche aus drei PNP-Transistoren 41, 43 und 44 aufgebaut ist, deren Emitter über Widerstände 42, 45 und 46 miteinander gekoppelt sind und deren Basis-Anschlüsse ebenfalls miteinander gekoppelt sind. Der Kollektor- und der Basis-Anschluß des Transistors 41 sind miteinander gekoppelt und bilden den Eingang der Stromspiegel-Schaltung. Die Kollektor-Anschlüsse der Transistoren 43 und 44 bilden die Ausgänge der Stromspiegel-Schaltung und liefern die Ausgleichsströme I₄ und I₅.

Der zweiten Stromspiegel-Schaltung 4 wird an ihrem Eingang ein von einem Generator 51 erzeugter Referenzstrom I_{Ref} zugeführt. Dieser Referenzstrom ist konstant. Die zweite Stromspiegel-Schaltung 4 ist mit Transistoren 52, 54 und 55 sowie Widerständen 53, 56 und 57 in entsprechender Weise wie die erste Stromspiegel-Schaltung 3 aufgebaut, in Unterschied zu dieser jedoch mit NPN-Transistoren.

Die Kollektoren der Transistoren 54 und 55 liefern Referenz-Steuerströme I₇ und I₈, die etwa gleiche Größe haben und die konstant sind, da der Eingangsstrom I_{Ref} der Stromspiegel-Schaltung 4 ebenfalls konstant ist.

Die Ausgleichsströme I₄ und I₅, die von der ersten Stromspiegelschaltung 3 geliefert werden, und die Referenzsteuerströme I₇ und I₈, die von der zweiten Stromspiegelschaltung 4 geliefert werden, werden an Knotenpunkten C und D zusammengeführt. Es tritt eine Überlagerung des Ausgleichsstromes I₄ mit dem Referenzstrom I₇ und des Ausgleichstromes I₅ mit dem Referenzsteuerstrom I₈ ein.

Durch diese Überlagerung an den Knotenpunkten C und D werden die Kompensationsströme I₄₇ und I₅₈ erzeugt, die Knotenpunkten B bzw. A zwischen den Eingängen 14 bzw. 15 des Multiplizierers und den Widerständen 11 bzw. 12 zugeführt werden.

Die Kompensationsschaltung 2 arbeitet wie folgt:

Zur Abstimmung der Integrations-Zeitkonstante des Integrator-Elementes wird die zweite Steuerspannung U₂ variiert. Infolgedessen wird der zweite Steuerstrom I₂ variiert, der dem Strom-Multiplizierer 13 zugeführt wird und der eine Veränderung derjenigen Impedanz bewirkt, die am Eingang des Gegentakt-Verstärkers 18 wirksam ist.

In einer Integrator-Filterschaltung sind in in der Figur nicht dargestellter Weise mehrere Integrator-Elemente 1 gemäß der Figur vorgesehen. Diese sind in an sich bekannter Weise verschaltet; ihre Zahl bestimmt die Ordnung der gesamten Integrator-Filterschaltung. Alle zusätzlich zu dem Integrator-Element 1 in der Figur dargestellten Schaltungselemente, insbesondere die Kompensationsschaltung 2, sind individuell einzeln für jedes Integrator-Element 1 einer Integrator-Filterschaltung vorzusehen. Durch die Wahl der Integrations-Zeitkonstanten der Integrator-Elemente 1 kann die Filterfrequenz der gesamten Integrator-Filteranordnung eingestellt werden. Die Elemente 31, 32, 41, 42, 51, 52 und 53 können ggf. für eine oder mehrere Integrator-Filterschaltungen nur einmal vorgesehen sein.

Der hierbei bei Anordnungen nach dem Stande der Technik auftretende Nachteil besteht darin, daß bei Variation des zweiten Steuerstromes I₂ zur Einstellung der Integrations-Zeitkonstanten dieser veränderte Steuerstrom I₂ auch in den Eingängen 14 bzw. 15 fließt. Er tritt dort jeweils in etwa halber Größe auf. Dies ist in der Figur durch die Pfeile I₂/2 an den beiden Eingängen 14 und 15 des Strom-Multiplizierers 13 gekennzeichnet. Dieser Umstand hat vor allem den Nachteil, daß bei einer Veränderung des Steuerstromes I₂ diese Ströme, die auch durch die Widerstände 11 und 12 fließen, den Aussteuerbereich verändern. Bei einer Verkleinerung des zweiten Steuerstroms I₂ fließen auch durch die Widerstände 11 und 12 kleinere Ströme I₂/2, so daß in diesem Bereich eine Verringerung des Aussteuerbereichs des Integrator-Elementes eintritt. Dieser Effekt ist unerwünscht.

Durch die Einspeisung der Kompensations-Ströme I₄₇ und I₅₈ an den Punkten A und B wird genau diese unerwünschte Variation der Ströme I₂/2 kompensiert, so daß in den Widerständen 11 und 12 unabhängig von dem Strom I₂ bzw. den Strömen I₂/2 ein konstanter Strom fließt.

Dies wird durch die folgenden Maßnahmen erreicht:

Der dritte Steuerstrom I₃, der in proportionaler Abhängigkeit vom Steuerstrom I₂ generiert wird, wird der ersten Stromspiegelschaltung 3 zugeführt, die die Ausgleichsströme I₄ und I₅ liefert, die sich somit ebenfalls proportional zum Steuerstrom I₂ und damit auch zu dem halbierten Steuerstrom I₂/2 an den Eingängen 14 und 15 des Strom-Multiplizierers 13 verhalten. Die Kompensationsströme I₄₇ und I₅₈ werden erzeugt, indem von den Ausgleichsströmen I₄ und I₅ jeweils ein konstanter Strom I₇ und I₈ subtrahiert wird. Die Kompensationsströme I₄₇ und I₅₈ liefern an den Knotenpunkten A und B jeweils einen Strom, dessen Größe denjenigen veränderten Stromanteilen in den Eingängen 14 und 15 des Strom-Multiplizierers 13 entspricht, die durch eine Veränderung des zweiten Steuerstromes I₂ eintreten. Erhöht sich beispielsweise der zweite Steuerstrom I₂ um ein bestimmtes Maß, so erhöhen sich auch die Ströme I₂/2 in den Eingängen 14 und 15 des Strom-Multiplizierers 13 proportional dazu in halber Größe. Genau diese Veränderung der Ströme I₂/2 in den Eingängen des Multiplizierers 14 und 15 wird durch die Kompensationsströme I₄₇ bzw. I₅₈ kompensiert, d.h. diese Ströme weisen die gleiche Größe auf wie die Veränderung der Ströme I₂/2 beträgt. Dies hat zur Folge, daß in den Widerständen 11 und 12, abgesehen von Einflüssen eines eventuell eingespeisten zu filternden Signals, konstante Ströme fließen. Damit wird bei einer Veränderung des Steuerstromes I₂ in diesem Bereich ein konstanter Aussteuerbereich realisiert.

Die Kompensationsschaltung 2 kann vorteilhaft so ausgelegt sein, daß bei einer Referenz-Integrations-Zeitkonstanten die Ströme I₄ und I₅ die gleiche Größe aufweisen wie die Ströme I₇ und I₈. Damit haben bei dieser Referenz-Integrations-Zeitkonstante die Kompensationsströme I₄₇ und I₅₈ den Wert Null. Somit fließt bei der Referenz-Integrations-Zeitkonstante der unveränderte Strom I₂/2 auch durch die Widerstände 11 und 12.

Wird nun der zweite Steuerstrom I₂ verändert, um eine veränderte Integrations-Zeitkonstante einzustellen, so wird beispielsweise bei einer Vergrößerung des Stromes I₂ auch eine Vergrößerung der Steuerstrom-Anteile I₂/2 in den Eingängen 14 und 15 des Strom-Multiplizierers 13 eintreten, wobei diese sich etwa nur um das halbe Maß erhöhen verglichen mit der Erhöhung des Steuerstromes I₂. Ohne Kompensation würden entsprechend vergrößerte Ströme in den Widerständen 11 und 12 fließen. Die Kompensationsschaltung 2 ist jedoch so ausgelegt, daß die Kompensationsströme I₄₇ und I₅₈ genau diesen veränderten Anteil in den Strömen I₂/2 kompensieren, d.h. die Kompensationsströme liefern jeweils einen Strom, der genau so groß ist wie die Veränderung der Ströme I₂/2 gegenüber der Referenz-Integrations-Zeitkonstanten.

Vorteilhafterweise kann diese Referenz-Integrations--Zeitkonstante so gewählt werden, daß sie in einem mittleren Bereich des Wahlbereiches der Integrations-Zeitkonstanten liegt. Damit wird erreicht, daß eine minimale Größe der Kompensationsströme I₄₇ und I₅₈ erforderlich ist.

In einer Integrator-Filterschaltung mit mehreren Integrator-Elementen 1 sind die Kompensationsströme mittels jeweils einer Kompensationsschaltung 2 individuell für jedes Integrator-Element 1 einzeln zu erzeugen bzw. vorgesehen. Es wird also für jedes Integrator-Element 1 individuell eine Kompensation der Veränderung der Steuerstromanteile an den Eingängen der Multiplizierer vorgenommen. Der dritte Steuerstrom und der Referenzstrom können jedoch nur einmal für mehrere FilterElemente oder mehrere Integrator-Filterschaltungen gemeinsam erzeugt werden.

## Patentansprüche

1. Integrator-Filterschaltung zur Filterung eines Gegentaktsignals mit wenigstens zwei Integrator-Elementen (1), welche jeweils eingangsseitig angeordnete Widerstände (11,12), einen diesen nachgeschalteten Strom-Multiplizierer (13) mit zwei Signaleingängen (14,15) und einen diesem nachgeschalteten Gegentaktverstärker (18) mit einem invertierenden (20) und einem nichtinvertierenden (19) Eingang aufweisen, dessen invertierender Ausgang (21) auf den nichtinvertierenden Eingang (19) und dessen nichtinvertierender Ausgang (23) auf dessen invertierenden Eingang (20) über Kapazitäten (22,24) rückgekoppelt ist, wobei dem Strom-Multiplizierer (13) an zwei Steuereingängen (37,38) ein erster und ein zweiter Steuerstrom (I₁,I₂) zugeführt werden, mittels derer die Integrations-Zeitkonstante der Integrator-Elemente (1) einstellbar ist und von denen der zweite Steuerstrom (I₂) etwa je hälftig durch die Signaleingänge (14,15) des Strom-Multiplizierers (13) fließt, **dadurch gekennzeichnet,**
**daß** ein zugeordneter dritter Steuerstrom (I₃) erzeugt wird, welcher in Abhängigkeit einer zweiten Steuerspannung (U₂) generiert wird, bei deren Variation der dritte Steuerstrom (I₃) sich proportional zu dem zweiten Steuerstrom (I₂) ändert, daß für jedes Integrator-Element (1) eine zugeordnete Kompensationsschaltung (2) vorgesehen ist, die eine erste Stromspiegelschaltung (3), welche in Abhängigkeit des dritten Steuerstromes (I₃) zwei etwa gleich große Ausgleichsströme (I₄,I₅) erzeugt, und eine zweite Stromspiegelschaltung (4) aufweist, welche in Abhängigkeit eines Referenzstromes (I_{Ref}) zwei gleich große Referenzsteuerströme (I₇,I₈) erzeugt, welche zur Erzeugung zweier Kompensationsströme (I₄₇,I₅₈) mit den Ausgleichsströmen (I₄,I₅) überlagert werden, und daß der dritte Steuerstrom (I₃) und die zugeordneten Kompensationsschaltungen (2) so dimensioniert sind, daß in Folge der Einspeisung der Kompensationsströme (I₄₇,I₅₈) an den Signaleingängen (14,15) der Strom-Multiplizierer (13) der Integrator-Elemente (1) bei einer Veränderung der Größe des zweiten Steuerstromes (I₂) die durch die Widerstände (11,12) fließenden Summenströme aus jeweils halbem zweitem Steuerstrom (I₂/2) und Kompensationsstrom (I₄₇ oder I₅₈) etwa konstant bleiben.

2. Integrator-Filterschaltung nach Anspruch 1, **dadurch gekennzeichnet,**
**daß** die Kompensationschaltung (2) so ausgelegt ist, daß die Kompensationsströme (I₄₇,I₅₈) bei einer Referenz-Integrator-Zeitkonstante Null betragen und daß bei Abstimmung eines Integrator-Elementes (1) auf von der Referenz-Integrator Zeitkonstante abweichenden Integrator-Zeitkonstanten die Kompensationsströme (I₄₇,I₅₈) mit zunehmender Abweichung der Integrationskonstante von der Referenz-Integrator-Zeitkonstante betragsmäßig immer größere Werte annehmen, so daß an den Signaleingängen (14,15) des Strom-Multiplizierers (13) eine Kompensation derjenigen Anteile des zweiten Steuerstroms (I₂) eintritt, die dort abweichend gegenüber den dort bei Abstimmung auf die Referenz-Integrator-Zeitkonstante auftretenden Anteilen des zweiten Steuerstroms (I₂) auftreten.

3. Integrator-Filterschaltung nach Anspruch 1, **dadurch gekennzeichnet,**
**daß** der erste und der zweite Steuerstrom (I₁,I₂) mittels je eines Transistors (33;35) in Abhängigkeit einer ersten bzw. der zweiten Steuerspannung (U₁,U₂) erzeugt werden, wobei die Kollektorströme der Transistoren (33,35) jeweils die Steuerströme (I₁,I₂) liefern und wobei die Transistoren (33,35), insbesondere über je einen Widerstand (34,36), mit einem Bezugspotential gekoppelt sind.

4. Integrator-Filterschaltung nach Anspruch 1, **dadurch gekennzeichnet,**
**daß** die ersten und zweiten Steuerströme (I₁,I₂) der Integrator-Elemente (1) sowohl für eine Wahl der Filterfrequenz der Integrator-Filterschaltung als auch für eine Feinabstimmung der Filterfrequenz der Integrator-Filterschaltung einsetzbar sind.

5. Integrator-Filterschaltung nach Anspruch 1, **dadurch gekennzeichnet,**
**daß** die Filterschaltung eingangsseitig einen Amplitudenbegrenzer aufweist, der so ausgelegt ist, daß unabhängig von der Amplitude des Eingangssignals keine Übersteuerung der Integrator-Filterschaltung eintreten kann.

6. Integrator-Filterschaltung nach Anspruch 1, **dadurch gekennzeichnet,**
**daß** die Integrator-Elemente (1) zur Ausfilterung eines Tonträgers eines der Integrator-Filterschaltung zugeführten Video-Signals ausgelegt sind und daß die Filter-Frequenz der Integrator-Filterschaltung mittels der ersten und zweiten Steuerströme (I₁,I₂) der Integrator-Elemente auf die Tonträgerfrequenz einstellbar ist.

7. Integrator-Filterschaltung nach Anspruch 1, **dadurch gekennzeichnet,**
**daß** die Integrator-Elemente (1) zur Ausfilterung eines Farbträgers eines der Integrator-Filterschaltung zugeführten Video-Signals ausgelegt sind und daß die Filter-Frequenz der Integrator-Filterschaltung mittels der ersten und zweiten Steuerströme (I₁,I₂) der Integrator-Elemente (1) auf die Farbträgerfrequenz einstellbar ist.

8. Filteranordnung mit mehreren Integrator-Filterschaltungen nach Anspruch 1.

9. Filteranordnung mit wenigstens zwei Integrator-Filterschaltungen nach Anspruch 1, **dadurch gekennzeichnet, daß** ein gemeinsamer dritter Steuerstrom (I₃) und/oder ein gemeinsamer Referenzstrom (I_{Ref}) für mehrere Integrator-Filterschaltungen erzeugt wird.

10. Filteranordnung mit wenigstens zwei Integrator-Filterschaltungen nach Anspruch 1, **dadurch gekennzeichnet,**
**daß** die Filteranordnung zur Ausfilterung eines zwei Tonträgern aufmodulierten Stereo- oder Zweiton-Signals eines der Integrator-Filterschaltung zugeführten Video-Signals ausgelegt sind, wobei eine erste Integrator-Filterschaltung zur Ausfilterung eines ersten Tonträgers und eine zweite Integrator-Filterschaltung zur Ausfilterung eines zweiten Tonträgers ausgelegt ist.

11. Filteranordnung mit drei Integrator-Filterschaltungen nach Anspruch 1, **dadurch gekennzeichnet,**
**daß** die Filteranordnung zur Ausfilterung eines zwei Tonträgern aufmodulierten Stereo- oder Zweiton-Signals eines der Integrator-Filterschaltung zugeführten Video-Signals ausgelegt sind, wobei eine erste und eine zweite Integrator-Filterschaltung zur Ausfilterung eines ersten Tonträgers ausgelegt sind und gegeneinander versetzte Filterfrequenzen aufweisen und wobei eine dritte Integrator-Filterschaltung zur Ausfilterung eines zweiten Tonträgers ausgelegt ist.

## Claims

1. An integrator-filter circuit for filtering a push-pull signal, comprising at least two integrator elements (1) having resistors (11, 12) arranged at their input, a subsequent current multiplier (13) having two signal inputs (14, 15) and preceding a push-pull amplifier (18) with an inverting input (20) and a non-inverting input (19), whose inverting output (21) is fed back to the non-inverting input (19) and the non-inverting output (23) is fed back to the inverting input (20) via capacitances (22, 24), the current multiplier (13) receiving at two control inputs (37, 38) a first and a second control current (I₁, I₂) by means of which the integration time constant of the integrator elements (1) is adjustable and from which the second control current (I₂) flows in substantially two halves through the signal inputs (14, 15) of the current multiplier (13), **characterized in that** an associated third control current (I₃) is generated which, in dependence upon a second control voltage (U₂) is generated, at whose variation the third control current (I₃) varies proportionally to the second control current (I₂), **in that** an associated compensation circuit (2) is provided for each integrator element (1), which compensation circuit comprises a first current mirror circuit (3) which generates two substantially equally large equalizing currents (I₄, I₅) in dependence upon the third control current (I₃), and a second current mirror circuit (4) which generates two equally large reference control currents (I₇, I₈) in dependence upon a reference current (I_{ref}), which reference currents are superimposed on the equalizing currents (I₄, I₅) for generating two compensation currents (I₄₇, I₅₈), and **in that** the third control current (I₃) and the associated compensation circuits (2) are dimensioned in such a way that, in response to the supply of the compensation currents (I₄₇, I₅₈) to the signal inputs (14, 15) of the current multiplier (13) of the integrator elements (1), the sum currents flowing through the resistors (11, 12) and constituted by half the second control current (I₂/2) and compensation current (I₄₇ or I₅₈) remain substantially constant when the value of the second control current (I₂) changes.

2. An integrator-filter circuit as claimed in claim 1, **characterized in that** the compensation circuit (2) is implemented in such a way that the compensation currents (I₄₇, I₅₈) are zero at a reference integrator time constant, and **in that** the compensation currents (I₄₇, I₅₈) assume increasingly larger values with an increasing deviation of the integration constant from the reference integrator time constant when an integrator element (1) is tuned to an integrator time constant which deviates from the reference integrator time constant, so that, at the signal inputs (14, 15) of the current multiplier (13), those parts of the second control current (I₂) are compensated which occur at said inputs and deviate from the portions of the second control current (I₂) occurring at said inputs when tuning to the reference integrator time constant.

3. An integrator-filter circuit as claimed in claim 1, **characterized in that** the first and the second control current (I₁, I₂) are generated by a respective transistor (33; 35) in dependence upon a first and the second control voltage (U₁, U₂), respectively, the collector currents of the transistors (33, 35) supplying the control currents (I₁, I₂), and the transistors (33, 35) being coupled to a reference potential, specifically through a respective resistor (34, 36).

4. An integrator-filter circuit as claimed in claim 1, **characterized in that** the first and second control currents (I₁, I₂) of the integrator elements (1) can be used both for selecting the filter frequency of the integrator-filter circuit and for fine-tuning the filter frequency of the integrator-filter circuit.

5. An integrator-filter circuit as claimed in claim 1, **characterized in that** the filter circuit comprises, at its input side, an amplitude limiter which is implemented in such a way that, independent of the amplitude of the input signal, overdrive of the integrator-filter circuit cannot occur.

6. An integrator-filter circuit as claimed in claim 1, **characterized in that** the integrator elements (1) are implemented for filtering a sound carrier of a video signal applied to the integrator-filter circuit, and **in that** the filter frequency of the integrator-filter circuit is adjustable to the sound carrier frequency by means of the first and second control currents (I₁, I₂) of the integrator elements.

7. An integrator-filter circuit as claimed in claim 1, **characterized in that** the integrator elements (1) are implemented for filtering a chrominance subcarrier of a video signal applied to the integrator-filter circuit, and **in that** the filter frequency of the integrator-filter circuit is adjustable to the chrominance subcarrier frequency by means of the first and second control currents (I₁, I₂) of the integrator elements (1).

8. A filter arrangement including a plurality of integrator-filter circuits as claimed in claim 1.

9. A filter arrangement including at least two integrator-filter circuits as claimed in claim 1, **characterized in that** a common, third control current (I₃) and/or a common reference current (I_{ref}) is generated for a plurality of integrator-filter circuits.

10. A filter arrangement including at least two integrator-filter circuit as claimed in claim 1, **characterized in that** the filter arrangement is implemented for filtering a stereo or two-tone signal modulated on two sound carriers of a video signal applied to the integrator-filter circuit, a first integrator-filter circuit being implemented for filtering a first sound carrier and a second integrator-filter circuit being implemented for filtering a second sound carrier.

11. A filter arrangement including three integrator-filter circuits as claimed in claim 1, **characterized in that** the filter arrangement is implemented for filtering a stereo or two-tone signal modulated on two sound carriers of a video signal applied to the integrator-filter circuit, a first and a second integrator-filter circuit being implemented for filtering a first sound carrier and having mutually offset filter frequencies, and a third integrator-filter circuit being implemented for filtering a second sound carrier.

## Revendications

1. Circuit filtre-intégrateur pour le filtrage d'un signal symétrique avec au moins deux éléments intégrateurs (1) qui présentent respectivement des résistances (11, 12) disposées côté entrée, un multiplicateur de courant (13) monté en aval de celles-ci avec deux entrées de signal (14, 15) et un amplificateur symétrique (18) monté en aval de celui-ci avec une entrée inversante (20) et une entrée non inversante (19) dont la sortie inversante (21) est réappliquée sur l'entrée non inversante (19) et dont la sortie non inversante (23) est réappliquée sur son entrée inversante (20) par l'intermédiaire de capacités (22, 24), des premier et deuxième courants de commande (I1, I2) étant amenés au multiplicateur de courant (13) aux deux entrées de commande (37, 38), courants à l'aide desquels la constante temps-intégration de l'élément intégrateur (1) est réglable et par lesquels le deuxième courant de commande (12) circule à raison d'une moitié chacune par les entrées de signal (14, 15) du multiplicateur de courant (13), **caractérisé en ce**
**qu'** il est produit un troisième courant de commande (13) affecté qui est généré en fonction d'une deuxième tension de commande (U2) dont la variation fait varier le troisième courant de commande (I3) proportionnellement au deuxième courant de commande (12), que, pour chaque élément intégrateur (1), il est prévu un circuit de compensation affecté (2) qui présente un premier circuit de miroir de courant (3) qui produit deux courants d'égalisation (14, 15) à peu près de même grandeur en fonction du troisième courant de commande (13) et un deuxième circuit de miroir de courant (4) qui produit deux courants de commande de référence (I7, I8) de même grandeur en fonction d'un courant de référence (Iref), qui sont superposés pour la production de deux courants de compensation (I47, I58) avec les courants d'égalisation (I4 et I5) et que le troisième courant de commande (13) et les courants de compensation (2) affectés sont dimensionnés de telle sorte qu'à la suite de l'alimentation des courants de compensation (I47, I48) aux entrées de signal (14, 15) du multiplicateur de courant (13) des éléments intégrateurs (1), les courants de somme circulant par la résistance (11, 12) et composés respectivement de la moitié du deuxième courant de commande (12/2) et du courant de compensation (147 ou 158) restent approximativement constants en cas de variation de la grandeur du deuxième courant de commande (12).

2. Circuit filtre-intégrateur selon la revendication 1, **caractérisé en ce que** le circuit de compensation (2) est conçu de telle sorte que les courants de compensation (147, I58) s'élèvent à zéro en cas de constante de temps de l'intégrateur de référence et qu'en cas de syntonisation d'un élément intégrateur (1) sur des constantes de temps de l'intégrateur dérogeant à la constante de temps de l'intégrateur de référence, les courants de compensation (I47, I58) avec un écart croissant de la constante d'intégration par rapport à la constante de temps de l'intégrateur de référence adoptent des valeurs toujours plus élevées en nombre de telle sorte qu'une compensation des composantes du deuxième courant de commande (12) qui s'y écartent des composantes du deuxième courant de commande (12) survenant en cas de syntonisation à la constante de temps de l'intégrateur de référence se produise aux entrées du signal (14, 15) du multiplicateur de courant (13).

3. Circuit filtre-intégrateur selon la revendication 1 **caractérisé en ce que** les premier et deuxième courants de commande (I1, 12) sont produits à l'aide d'un transistor (33, 35) respectif en fonction de première ou deuxième tensions de commande (U1, U2), les courants de collecteur des transistors (33, 35) délivrant respectivement les courants de commande (I1, 12) et les transistors (33, 35) étant en particulier couplés par l'intermédiaire d'une résistance (34, 36) respective avec un potentiel de référence.

4. Circuit filtre-intégrateur selon la revendication 1, **caractérisé en ce que** les premier et deuxième courants de commande (I1, I2) des éléments intégrateurs (1) peuvent être utilisés à la fois pour une sélection de la fréquence de filtrage du circuit filtre-intégrateur et pour une syntonisation fine de la fréquence de filtrage du circuit filtre-intégrateur.

5. Circuit filtre-intégrateur selon la revendication 1, **caractérisé en ce que** le circuit de filtrage présente côté entrée un limiteur d'amplitude qui est conçu de telle sorte qu'il ne puisse se produire de saturation du circuit filtre-intégrateur, indépendamment de l'amplitude du signal d'entrée.

6. Circuit filtre-intégrateur selon la revendication 1, **caractérisé en ce que** les éléments intégrateurs (1) sont conçus pour le filtrage d'une porteuse audio d'un signal vidéo amené au circuit filtre-intégrateur et que la fréquence de filtrage du circuit filtre-intégrateur peut être réglée à l'aide des premier et deuxième courants de commande (I1, 12) des éléments intégrateurs sur la fréquence porteuse audio.

7. Circuit filtre-intégrateur selon la revendication 1, **caractérisé en ce que** les éléments intégrateurs (1) sont conçus pour le filtrage d'une porteuse couleur d'un signal vidéo amené au circuit filtre-intégrateur et que la fréquence de filtrage du circuit filtre-intégrateur peut être réglée à l'aide des premier et deuxième courants de commande (I1, I2) des éléments intégrateurs sur la fréquence porteuse couleur.

8. Dispositif de filtrage avec plusieurs circuits filtres-intégrateurs selon la revendication 1.

9. Dispositif de filtrage avec au moins deux circuits filtres-intégrateurs selon la revendication 1, **caractérisé en ce qu'**un troisième courant de commande (13) commun et/ou un courant de référence (Iref) commun est produit pour plusieurs circuits filtres-intégrateurs.

10. Dispositif de filtrage avec au moins deux circuits filtres-intégrateurs selon la revendication 1, **caractérisé en ce que** le dispositif de filtrage est conçu pour le filtrage d'un signal stéréo ou audio différentiel modulé sur deux porteuses audio d'un signal vidéo amené au circuit filtre-intégrateur, un premier circuit filtre-intégrateur étant conçu pour le filtrage d'une première porteuse audio et un deuxième circuit filtre-intégrateur pour le filtrage d'une deuxième porteuse audio.

11. Dispositif de filtrage avec trois circuits filtres-intégrateurs selon la revendication 1, **caractérisé en ce que** le dispositif de filtrage est conçu pour le filtrage d'un signal stéréo ou différentiel modulé sur deux porteuses audio d'un signal vidéo amené au circuit filtre-intégrateur, des premier et deuxième circuits filtres-intégrateurs étant conçus pour le filtrage d'une première porteuse audio et présentant des fréquences de filtrage décalées l'une par rapport à l'autre et un troisième circuit filtre-intégrateur étant conçu pour le filtrage d'une deuxième porteuse audio.
